# EUROPEAN PATENT APPLICATION

(11) **EP 4 761 090 A1**
(43) Date of publication of application: **17.06.2026**
(21) Application number: 24861556.9
(22) Date of filing: 22.05.2024
(51) Int. Cl.: H02M 7/00, H02M 7/42, H02S 40/32, H05K 5/02

(54) **PHOTOVOLTAIC INVERTER AND ROTARY SWITCH**

(30) Priority: 05.09.2023 CN 202322409989 U
(71) Applicant: Huawei Digital Power Technologies Co., Ltd., Shenzhen, Guangdong 518043 (CN)
(72) Inventor: GAO, Feng, Shenzhen, Guangdong 518043 (CN); SUN, Jisheng, Shenzhen, Guangdong 518043 (CN); CHEN, Chao, Shenzhen, Guangdong 518043 (CN); YU, Huiyong, Shenzhen, Guangdong 518043 (CN); HAN, Xiaoliang, Shenzhen, Guangdong 518043 (CN)
(74) Representative: Gill Jennings & Every LLP
(86) International application number: PCT/CN2024/094714
(87) International publication number: WO 2025/050708

(57) **Abstract**

This application provides a photovoltaic inverter and a rotary switch. The photovoltaic inverter includes the rotary switch. The rotary switch includes a switch body. The switch body includes an insulation housing and a plurality of pins. Ends of the plurality of pins extending out of the insulation housing are connected to a circuit board. The rotary switch is a multipole switch. Each pole of the rotary switch includes two pins. The insulation housing is provided with a groove or a boss between two pins that are located on a same side and that are of two adjacent poles. Alternatively, a portion that is of each pin and that is located between the insulation housing and the circuit board is surrounded by a rib. Based on this solution, a creepage distance and an electrical clearance between pins of two adjacent poles are increased. This ensures electrical stability and performance of the photovoltaic inverter, and facilitates miniaturization of the photovoltaic inverter and the rotary switch.

## Description

This application claims priority to Chinese Patent Application No. 202322409989.9, filed with the China National Intellectual Property Administration on September 5, 2023 and entitled "PHOTOVOLTAIC INVERTER AND ROTARY SWITCH", which is incorporated herein by reference in its entirety.

### TECHNICAL FIELD

This application relates to the field of photovoltaic technologies, and specifically, to a photovoltaic inverter and a rotary switch.

### BACKGROUND

In a photovoltaic power generation system, a photovoltaic inverter may convert a direct current input by a photovoltaic module into an alternating current. A user can control a photovoltaic input to be switched on or off through a rotary switch. However, in a case of a high voltage, to implement a requirement of insulation between a positive pole and a negative pole of the rotary switch of the photovoltaic inverter, a thickness of the rotary switch may be increased. This is unconducive to miniaturization of the rotary switch and the photovoltaic inverter.

### SUMMARY

This application provides a photovoltaic inverter and a rotary switch. An insulation housing of the rotary switch is provided with a groove or a boss between two pins that are located on a same side and that are of two adjacent poles. Alternatively, a portion that is of each pin and that is located between the insulation housing and a circuit board is surrounded by a rib. In this way, a creepage distance and an electrical clearance between pins of two adjacent poles are increased. This ensures electrical stability and performance of the photovoltaic inverter, and facilitates miniaturization of the photovoltaic inverter and the rotary switch.

According to a first aspect, a photovoltaic inverter is provided, including a rotary switch. The rotary switch includes a switch body. The switch body includes an insulation housing and a plurality of pins. The plurality of pins extend out of the insulation housing from a side that is of the insulation housing and that is close to a circuit board. The rotary switch is a multipole switch. Each pole of the rotary switch includes two pins. The insulation housing is provided with a groove between two pins that are located on a same side and that are of two adjacent poles. An opening of the groove is located on a side, on which the plurality of pins are located, of the insulation housing. Alternatively, a boss is formed on an outer side wall of the insulation housing. The boss is located between the two pins that are located on the same side and that are of the two adjacent poles.

In this embodiment of this application, the groove or the boss is added between pins of two adjacent poles, so that a creepage distance or an electrical clearance between pins located on a same side can be increased. This ensures electrical stability and performance of the photovoltaic inverter. In addition, due to existence of the groove or the boss, a creepage distance and an electrical clearance between pins located on a same side are large, and a spacing distance between pins may be small. This facilitates miniaturization of the rotary switch and the photovoltaic inverter.

With reference to the first aspect, in a possible implementation, the photovoltaic inverter further includes the circuit board. Portions of the plurality of pins extending out of the insulation housing are located between the insulation housing and the circuit board. Ends of the plurality of pins extending out of the insulation housing are connected to a side that is of the circuit board and that is close to the insulation housing.

With reference to the first aspect, in a possible implementation, the photovoltaic inverter further includes a case. The circuit board is located in an accommodating cavity enclosed by the case. The circuit board divides the accommodating cavity enclosed by the case into a first cavity and a second cavity. The first cavity is accommodation space enclosed by the circuit board, a bottom plate of the case, and a side plate of the case. The second cavity is accommodation space enclosed by the circuit board, a top plate of the case, and the side plate of the case. A distance between the circuit board and the bottom plate is greater than a distance between the circuit board and the top plate. A height of an electrical component connected to a side that is of the circuit board and that is close to the bottom plate is greater than or equal to a first preset value. A height of an electrical component connected to a side that is of the circuit board and that is close to the top plate is less than or equal to a second preset value. The first preset value is greater than the second preset value. The switch body is located in the first cavity.

With reference to the first aspect, in a possible implementation, a side wall that is of the insulation housing and that is close to the circuit board is provided with a plurality of through holes. The plurality of pins are in a one-to-one correspondence with the plurality of through holes. The plurality of pins extend out of the insulation housing through the plurality of through holes.

With reference to the first aspect, in a possible implementation, the plurality of pins are connected to the circuit board through welding.

With reference to the first aspect, in a possible implementation, there are one or more grooves between a first pin and a second pin, or there are one or more bosses between the first pin and the second pin.

According to a second aspect, a photovoltaic inverter is provided, including a rotary switch. The rotary switch includes a switch body. The switch body includes an insulation housing and a plurality of pins. The plurality of pins extend out of the insulation housing. The insulation housing further includes a plurality of ribs. The plurality of ribs protrude from an outer side wall of the insulation housing. The plurality of ribs are in a one-to-one correspondence with the plurality of pins. The rotary switch is a multipole switch. Each pole of the rotary switch includes two pins. At least portions of the plurality of ribs are located between two pins that are located on a same side and that are of two adjacent poles.

In this embodiment of this application, the at least portions of the plurality of ribs are located between the two pins that are on the same side and that are of the two adjacent poles, so that a creepage distance and an electrical clearance between pins located on a same side can be increased. This ensures electrical stability and performance of the photovoltaic inverter. In addition, due to existence of the rib, a creepage distance and an electrical clearance between pins located on a same side are large, and a spacing distance between the pins on the same side may be small. This facilitates miniaturization of the rotary switch and the photovoltaic inverter.

With reference to the second aspect, in a possible implementation, the photovoltaic inverter further includes a circuit board. Portions of the plurality of pins extending out of the insulation housing are located between the insulation housing and the circuit board. Ends of the plurality of pins extending out of the insulation housing are connected to a side that is of the circuit board and that is close to the insulation housing.

With reference to the second aspect, in a possible implementation, a first rib surrounds a periphery of a portion that is of a first pin and that is located between the insulation housing and the circuit board.

In this embodiment of this application, the rib surrounds the periphery of the portion of the pin extending out of the housing, so that a creepage distance and an electrical clearance between the pin and a surrounding conductive member (for example, another pin) can be increased. This helps comprehensively improve electrical stability and performance of the photovoltaic inverter.

With reference to the second aspect, in a possible implementation, the insulation housing is provided with a groove between two adjacent ribs. An opening of the groove is located on a side, on which the plurality of pins are located, of the insulation housing. The two adjacent ribs are two ribs corresponding to the two pins that are located on the same side and that are of the two adjacent poles.

In this embodiment of this application, the groove may be further provided between the two pins that are located on the same side and that are of the two adjacent poles, to further increase a creepage distance between the pins located on the same side. This further improves electrical stability and performance of the photovoltaic inverter.

With reference to the second aspect, in a possible implementation, the insulation housing further includes a boss. The boss is located on a side that is of the insulation housing and that is close to the circuit board. The boss is located between the two adjacent ribs. The two adjacent ribs are two ribs corresponding to the two pins that are located on the same side and that are of the two adjacent poles.

In this embodiment of this application, the boss may be further provided between the two pins that are located on the same side and that are of the two adjacent poles, to further increase a creepage distance and an electrical clearance between the pins located on the same side. This further improves electrical stability and performance of the photovoltaic inverter.

According to a third aspect, a rotary switch is provided, including a switch body. The switch body includes an insulation housing and a plurality of pins. The plurality of pins are located in an accommodating cavity enclosed by the insulation housing. The plurality of pins extend out of the insulation housing. Ends of the plurality of pins extending out of the insulation housing are configured to connect to a circuit board of a photovoltaic inverter. The rotary switch is a multipole switch. Each pole of the rotary switch includes two pins. The insulation housing is provided with a groove between two pins that are located on a same side and that are of two adjacent poles. An opening of the groove is located on a side, on which the plurality of pins are located, of the insulation housing. Alternatively, the insulation housing includes a boss. The boss is located on a side that is of the insulation housing and that is close to the circuit board. The boss is located between the two pins that are located on the same side and that are of the two adjacent poles.

It should be understood that, for beneficial effects of any one of the third aspect and the possible implementations of the third aspect, refer to related descriptions of the first aspect. Details are not described herein again.

With reference to the third aspect, in a possible implementation, the photovoltaic inverter further includes a case. The circuit board is located in an accommodating cavity enclosed by the case. The circuit board divides the accommodating cavity enclosed by the case into a first cavity and a second cavity. The first cavity is accommodation space enclosed by the circuit board, a bottom plate of the case, and a side plate of the case. The second cavity is accommodation space enclosed by the circuit board, a top plate of the case, and the side plate of the case. A distance between the circuit board and the bottom plate is greater than a distance between the circuit board and the top plate. A height of an electrical component connected to a side that is of the circuit board and that is close to the bottom plate is greater than or equal to a first preset value. A height of an electrical component connected to a side that is of the circuit board and that is close to the top plate is less than or equal to a second preset value. The first preset value is greater than the second preset value. The switch body is located in the first cavity.

According to a fourth aspect, a rotary switch is provided, including a switch body. The switch body includes an insulation housing and a plurality of pins. The plurality of pins are located in an accommodating cavity enclosed by the insulation housing. The plurality of pins extend out of the insulation housing. Ends of the plurality of pins extending out of the insulation housing are configured to connect to a circuit board of a photovoltaic inverter. The insulation housing further includes a plurality of ribs. The plurality of ribs protrude from a side wall that is of the insulation housing and that is close to the circuit board. The plurality of ribs are in a one-to-one correspondence with the plurality of pins. The rotary switch is a multipole switch. Each pole of the rotary switch includes two pins. At least portions of the plurality of ribs are located between two pins that are located on a same side and that are of two adjacent poles.

It should be understood that, for beneficial effects of any one of the fourth aspect and the possible implementations of the fourth aspect, refer to related descriptions of the second aspect. Details are not described herein again.

With reference to the fourth aspect, in a possible implementation, the insulation housing is provided with a groove between two adjacent ribs. An opening of the groove is located on a side, on which the plurality of pins are located, of the insulation housing. The two adjacent ribs are two ribs corresponding to the two pins that are located on the same side and that are of the two adjacent poles.

With reference to the fourth aspect, in a possible implementation, the insulation housing further includes a boss. The boss is located on a side that is of the insulation housing and that is close to the circuit board. The boss is located between the two adjacent ribs. The two adjacent ribs are two ribs corresponding to the two pins that are located on the same side and that are of the two adjacent poles.

### BRIEF DESCRIPTION OF DRAWINGS

FIG. 1 is a diagram of a photovoltaic power generation system according to an embodiment of this application;
FIG. 2 is a diagram of a structure of a photovoltaic inverter according to an embodiment of this application;
FIG. 3 is a diagram of a circuit structure of a photovoltaic inverter according to an embodiment of this application;
FIG. 4 is a diagram of a structure of a photovoltaic inverter according to an embodiment of this application;
FIG. 5 is a diagram of a structure of a switch body according to an embodiment of this application;
FIG. 6 is a diagram of a structure of another switch body according to an embodiment of this application;
FIG. 7 is a diagram of a structure of still another switch body according to an embodiment of this application; and
FIG. 8 is a diagram of a structure of another switch body according to an embodiment of this application.

### DESCRIPTION OF EMBODIMENTS

The following describes technical solutions of this application with reference to accompanying drawings.

In the descriptions of embodiments of this application, unless otherwise stated, "/" means "or", for example, A/B may represent A or B. In this specification, "and/or" describes only an association relationship between associated objects, and indicates that three relationships may exist. For example, A and/or B may represent three cases: Only A exists, both A and B exist, and only B exists.

In embodiments of this application, prefix words such as "first", "second", and "third" are used only to distinguish different described objects, and do not limit a location, a sequence, a priority, a quantity, or content of described objects. In embodiments of this application, use of the prefix word, for example, an ordinal number, used to distinguish between described objects does not constitute a limitation on the described objects. For descriptions of the described objects, refer to the descriptions of the context in the claims or embodiments. The use of such a prefix word should not constitute a redundant limitation. In the descriptions of embodiments, unless otherwise stated, "a plurality of" means two or more.

In embodiments of this application, an orientation or a position relationship indicated by the terms "upper", "lower", "left", "right", "front", "rear", "top", "bottom", "inner", "outer", and the like indicate an orientation or a position relationship shown in the accompanying drawings, and is merely intended to facilitate description and simplify description of this application, but is not intended to indicate or imply that a specified apparatus or element needs to have a specific orientation, be constructed in a specific orientation, and operate in a specific orientation. Therefore, this application cannot be construed as a limitation.

Reference to "some embodiments" or the like described in this specification indicates that one or more embodiments of this application include a specific feature, structure, or characteristic described with reference to embodiments. Therefore, statements such as "in some embodiments" that appear at different places in this specification do not necessarily mean referring to a same embodiment. Instead, the statements mean "one or more but not all of embodiments", unless otherwise specifically emphasized in another manner. The terms "include", "comprise", "have", and variants thereof all mean "include but are not limited to", unless otherwise specifically emphasized in another manner.

In this application, "vertical" is not vertical in a strict sense, but is within an allowed error range. "Parallel" is not parallel in a strict sense, but is within an allowed error range.

In embodiments of this application, a same reference numeral represents a same component part or a same part or component. In embodiments of this application, for a plurality of same parts or components, only one of the parts or components may be used as an example to mark a reference numeral in the figure. For another same part or component, reference numerals are also applicable. In addition, dimensions and sizes of the parts or components shown in the figure are merely examples.

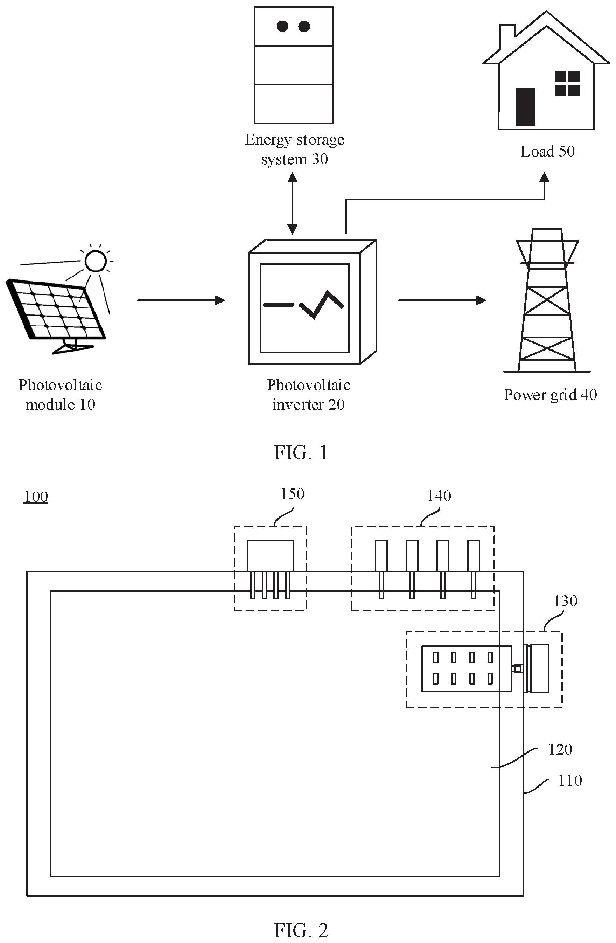

The following first describes in detail a photovoltaic power generation system provided in embodiments of this application with reference to FIG. 1.

FIG. 1 is a diagram of a photovoltaic power generation system according to an embodiment of this application. As shown in FIG. 1, the photovoltaic power generation system may include a photovoltaic module 10, a photovoltaic inverter 20, and an energy storage system 30.

Optionally, the photovoltaic power generation system may further include a power grid 40 and a load 50.

Specifically, the photovoltaic inverter 20 can convert a direct current from the photovoltaic module 10 into an alternating current, and transmit the alternating current to the power grid 40 or the load 50. The photovoltaic inverter 20 can transmit a direct current from the photovoltaic module 10 to the energy storage system 30, for charging the energy storage system 30. The photovoltaic inverter 20 can convert a direct current from the energy storage system 30 into an alternating current, and transmit the alternating current to the power grid 40 or the load 50.

It may be understood that when the photovoltaic power generation system includes the photovoltaic module 10, the photovoltaic inverter 20, and the energy storage system 30, the photovoltaic inverter 20 is mainly configured to connect the photovoltaic module 10 to the energy storage system 30, for charging the energy storage system 30. When the photovoltaic power generation system includes the photovoltaic module 10, the photovoltaic inverter 20, the energy storage system 30, the power grid 40, and the load 50, the photovoltaic inverter 20 can be configured to connect the foregoing apparatuses. For example, the photovoltaic inverter 20 connects the photovoltaic module 10 to the energy storage system 30, the photovoltaic inverter 20 connects the photovoltaic module 10 to the power grid 40, the photovoltaic inverter 20 connects the photovoltaic module 10 to the load 50, and the photovoltaic inverter 20 connects the load 50 to the energy storage system 30.

The energy storage system 30 in the photovoltaic power generation system can store and release electric energy. For example, the energy storage system 30 may store direct current electric energy from the photovoltaic module 10, and the energy storage system 30 may supply power to the power grid 40 or the load 50 through the photovoltaic inverter 20. Therefore, application scenarios of the energy storage system 30 are wide, including but not limited to a household scenario, an industry green power scenario, a smart photovoltaic power station scenario, and the like.

It can be learned from the foregoing description that the photovoltaic inverter 20 is a converter that can convert a direct current into an alternating current. For example, the photovoltaic inverter 20 may include two direct current ports (for example, a direct current port 1 and a direct current port 2) and one alternating current port. The two direct current ports are respectively configured to connect to the photovoltaic module 10 and the energy storage system 30. For example, the direct current port 1 is configured to connect to the photovoltaic module 10, the direct current port 2 is configured to connect to the energy storage system 30, and the alternating current port may be configured to connect to the power grid 40 or the load 50.

The photovoltaic module 10 may feed the power grid 40 and supply power to the load 50 through the direct current port 1. The energy storage system 30 may supply power to the load 50 through the direct current port 2. The power grid 40 may supply power to the load 50 through the alternating current port. In other words, the photovoltaic inverter 20 is a connection hub between the load 50 and an energy module (which may include the photovoltaic module 10, the energy storage system 30, and the power grid 40).

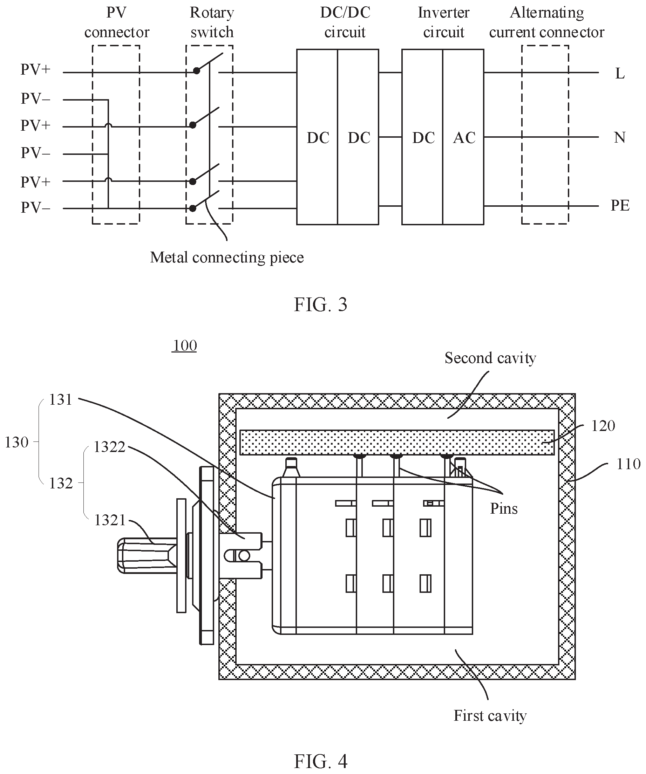

FIG. 2 is a top view of a photovoltaic inverter 100 according to an embodiment of this application. FIG. 3 is a diagram of a circuit structure of a photovoltaic inverter according to an embodiment of this application. The photovoltaic inverter 100 shown in FIG. 2 may be an example structure of the photovoltaic inverter 20 shown in FIG. 1.

As shown in FIG. 2, in a photovoltaic power generation system, the photovoltaic inverter 100 includes components such as a case 110, a circuit board 120, a rotary switch 130, a photovoltaic connector 140, and an alternating current connector 150. The circuit board 120 is located in an accommodating cavity enclosed by the case 110, and is mainly configured to convert a direct current into an alternating current of the photovoltaic inverter. The rotary switch 130 is mainly used to conduct or cut off a current. The alternating current connector 150 is configured to transmit the alternating current to a power grid and/or a load. One end of the photovoltaic connector 140 is connected to the circuit board 120, and the other end is connected to a photovoltaic module (or a photovoltaic string). The photovoltaic connector 140 is configured to input, to the circuit board 120, a direct current generated by the photovoltaic module by using light energy. The photovoltaic connector 140 may include a plurality of positive connectors and a plurality of negative connectors. The plurality of positive connectors are in a one-to-one correspondence with the plurality of negative connectors. The positive connector may be connected to a positive electrode of a photovoltaic module, and a negative connector corresponding to the positive connector is connected to a negative electrode of the photovoltaic module, so that a direct current generated by the photovoltaic module by using light energy may be input to the circuit board 120.

In this embodiment of this application, components such as the rotary switch 130, the photovoltaic connector 140, and the alternating current connector 150 are all board-mounted onto the circuit board 120. The foregoing components may be connected to each other by using metal traces on the circuit board 120, to form a circuit structure shown in FIG. 3. In this way, the rotary switch 130, the photovoltaic connector 140, the alternating current connector 150, and the circuit board 120 are connected without a cable, improving space utilization of the photovoltaic inverter.

In an example, the circuit board 120 may include an inverter circuit (DC/AC circuit), and the inverter circuit is configured to convert a direct current into an alternating current. The rotary switch 130 is located between the photovoltaic connector 140 and the DC/AC circuit, to control a current between the photovoltaic connector 140 and the DC/AC circuit to be switched on or off, that is, control a photovoltaic (direct current) input.

In another example, the circuit board 120 may further include a DC/DC circuit, the DC/DC circuit is configured to convert a direct current of a voltage value into a direct current of another voltage value, and an output end of the DC/DC circuit is connected to an input end of the DC/AC circuit. One end of the rotary switch 130 is electrically connected to the photovoltaic connector 140, and the other end of the rotary switch 130 is electrically connected to the DC/DC circuit, to control a photovoltaic (direct current) input.

It should be understood that, to implement a function of the photovoltaic inverter 100, the circuit board 120 may further include another circuit, for example, a rectifier circuit (AC/DC circuit) configured to convert an alternating current into a direct current. A type and a quantity of circuits disposed on the circuit board 120 are not limited in this embodiment of this application.

In this application, the circuit board 120 may also be referred to as a printed circuit board or a mainboard. The printed circuit board is a support body of an electronic component, and is also used as a carrier for electrical connection of the electronic component. Usually, a printed circuit board on which no electronic component is welded may be referred to as a PCB board. A printed circuit board on which electronic components are welded may be referred to as a printed circuit board assembly (printed circuit board assembly, PCBA). A conductive pattern or a metal trace is disposed on the circuit board, and the electronic components may be electrically connected by using the conductive pattern or the metal trace. The electronic components carried on the circuit board may form a plurality of functional modules to implement corresponding functions. For example, an inverter circuit module is configured to convert a direct current into an alternating current, and a rectifier circuit module is configured to convert an alternating current into a direct current.

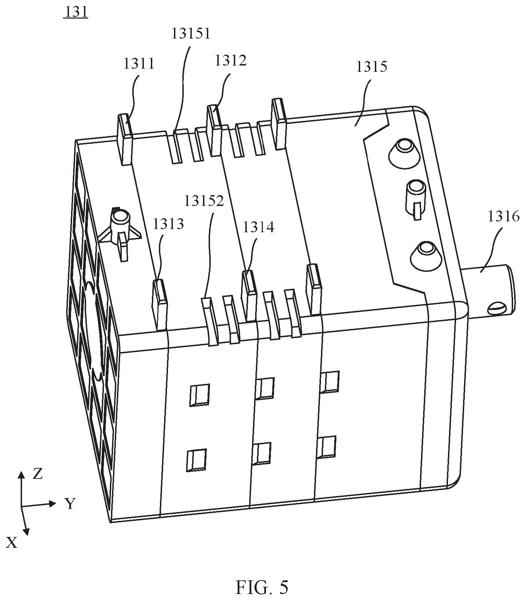

FIG. 4 is a diagram of a structure of a photovoltaic inverter according to an embodiment of this application. FIG. 5 is a diagram of a structure of a switch body according to an embodiment of this application.

As shown in FIG. 2 and FIG. 4, the photovoltaic inverter 100 may include a case 110, a circuit board 120, and a rotary switch 130. The case 110 may include a top plate, a bottom plate, and a side plate. The top plate, the bottom plate, and the side plate of the case 110 may form an accommodating cavity. The top plate and the bottom plate of the case 110 are disposed opposite to each other.

The circuit board 120 is located in the accommodating cavity enclosed by the case 110, and the circuit board 120 divides the accommodating cavity enclosed by the case 110 into a first cavity and a second cavity. The first cavity is accommodation space enclosed by the bottom plate of the case 110, the side plate of the case 110, and the circuit board 120. The second cavity is accommodation space enclosed by the top plate of the case 110, the side plate of the case 110, and the circuit board 120. In addition, a distance between the circuit board 120 and the bottom plate of the case 110 is greater than a distance between the circuit board 120 and the top plate of the case 110, that is, a height of the first cavity is greater than a height of the second cavity.

In some embodiments, the circuit board 120 is parallel to the bottom plate and/or the top plate of the case 110.

In this embodiment of this application, electrical components are mounted on both sides of the circuit board 120. That is, some electrical components are located in the first cavity, and these electrical components are connected to a side that is of the circuit board 120 and that is close to the bottom plate of the case 110. The other electrical components are located in the second cavity, and these electrical components are connected to a side that is of the circuit board 120 and that is close to the top plate of the case 110.

Specifically, the first cavity may be configured to accommodate some electrical components with a large size, a great height, or a large power, for example, large electrical components such as a power inductor, a bus capacitor, a power module, and a switching transistor. The second cavity may be configured to accommodate some electrical components with a small size, a low height, or a low power, for example, small electrical components such as a surface mount capacitor, a surface mount resistor, or an indicator light.

In some embodiments, the photovoltaic inverter 100 may further include a heat sink, and the heat sink is connected to a side that is of the bottom plate of the case 110 and that is away from the circuit board 120. Therefore, a condition for heat dissipation of the electrical component in the first cavity is good. The large electrical component has a high power and a high heat generation amount. Mounting the large electrical component on a side that is of the circuit board 120 and that is close to the bottom plate of the case 110 helps improve heat dissipation effect of the photovoltaic inverter.

In some embodiments, the first cavity is configured to accommodate an electrical component whose height is greater than or equal to a first preset value. The second cavity is configured to accommodate an electrical component whose height is less than or equal to a second preset value. The first preset value is greater than the second preset value. That is, a height of the electrical component connected to the side that is of the circuit board and that is close to the bottom plate is greater than or equal to the first preset value, and a height of the electrical component connected to the side that is of the circuit board and that is close to the top plate is less than or equal to the second preset value.

It should be understood that the first preset value and the second preset value may be preset by a skilled person. For example, the first preset value may be approximately 9 mm, and the second preset value may be approximately 5 mm.

It should be understood that conductive patterns or metal traces are disposed on both sides of the circuit board 120.

It should be understood that the first cavity may alternatively accommodate some electrical components with a small size and a low height, for example, an electrical component with a small size but a high heat generation amount. That is, the height of the electrical component connected to the side that is of the circuit board 120 and that is close to the bottom plate may alternatively be less than the first preset value. However, due to a limitation of the heights of the first cavity and the second cavity, the first cavity and the second cavity cannot accommodate electrical components whose heights exceed the limitation.

It should be understood that, according to an actual requirement, the electrical components connected to the circuit board 120 may be properly arranged on two sides of the circuit board 120, to improve space utilization of the photovoltaic inverter and improve heat dissipation effect of the photovoltaic inverter.

As shown in FIG. 4, the rotary switch 130 includes a switch body 131 and a handle assembly 132. The switch body 131 is located in the first cavity. The switch body 131 may include a plurality of pins, and the switch body 131 is connected to the circuit board 120 through the plurality of pins.

In an example, the plurality of pins of the switch body 131 may be connected to the circuit board 120 through welding. As shown in FIG. 4, a black semicircle pattern represents a welding joint between the pin and the circuit board 120.

As shown in FIG. 4 and FIG. 5, the rotary switch 130 in this application may be a multipole switch, and each pole of the rotary switch 130 may include two pins. For example, the rotary switch 130 is a dual-pole switch. A first pole of the rotary switch 130 includes a first pin 1311 and a third pin 1313, and a second pole of the rotary switch 130 includes a second pin 1312 and a fourth pin 1314.

For each pole of the rotary switch 130, one pin is electrically connected to the photovoltaic connector 140 by using a metal trace on the circuit board 120, and the other pin is electrically connected to the inverter circuit (or the DC/DC circuit, or the like) by using a metal trace on the circuit board 120. For example, the third pin 1313 of the first pole and the fourth pin 1314 of the second pole are connected to an input side of the inverter circuit (or the DC/DC circuit, or the like) on the circuit board 120. The first pin 1311 of the first pole is electrically connected to the positive connector of the photovoltaic connector 140, and the second pin 1312 of the second pole is electrically connected to the negative connector of the photovoltaic connector 140. Alternatively, the first pin 1311 of the first pole is electrically connected to one positive connector of the photovoltaic connector 140, and the second pin 1312 of the second pole is electrically connected to another positive connector of the photovoltaic connector 140.

It should be understood that the rotary switch in this application may be, for example, a dual-pole switch, a triple-pole switch, or a quad-pole switch. This is not limited in embodiments of this application.

The switch body 131 may further include an insulation housing 1315, and the plurality of pins of the switch body 131 are located in an accommodating cavity enclosed by the insulation housing 1315. A side wall that is of the insulation housing 1315 and that is close to the circuit board 120 is provided with a plurality of through holes. The plurality of pins may extend out of the insulation housing 1315 from the plurality of through holes. Ends of the plurality of pins extending out of the insulation housing 1315 are connected to a side that is of the circuit board 120 and that is close to the switch body 131. It may be understood that the plurality of pins of the switch body 131 include portions located in the accommodating cavity enclosed by the insulation housing 1315 and portions extending out of the insulation housing 1315. The portions of the plurality of pins extending out of the insulation housing 1315 are located between the insulation housing 1315 and the circuit board 120.

It should be understood that the insulation housing 1315 is made of an insulation material, for example, plastic.

Still refer to FIG. 3 and FIG. 4. The switch body 131 may further include a metal connecting piece and a rotating shaft 1316. The metal connecting piece is located in the accommodating cavity enclosed by the insulation housing 1315, and is located between two pins of a same pole. The rotating shaft 1316 is connected to the metal connecting piece, so that the metal connecting piece can rotate with rotation of the rotating shaft 1316, and the rotary switch 130 conducts or cuts off a current.

For example, a first metal connecting piece is disposed between the first pin 1311 and the third pin 1313, and a second metal connecting piece is disposed between the second pin 1312 and the fourth pin 1314. The rotating shaft 1316 rotates, so that the first metal connecting piece and the second metal connecting piece rotate accordingly, the first pin 1311 is electrically connected to the third pin 1313 through the first metal connecting piece, and the second pin 1312 is electrically connected to the fourth pin 1314 through the first metal connecting piece; or the first pin 1311 is disconnected from the third pin 1313, and the second pin 1312 is disconnected from the fourth pin 1314.

In this embodiment of this application, the metal connecting piece and the rotating shaft 1316 may be of an integrated structure, or may be of a separate structure. This is not limited in embodiments of this application. When the metal connecting piece and the rotating shaft 1316 are of a separate structure, the metal connecting piece and the rotating shaft 1316 are two different components, and the metal connecting piece and the rotating shaft 1316 may be assembled together through clamping, fastening, a screw, a bolt, or the like, and may be separated when the metal connecting piece and the rotating shaft 1316 need to be disassembled. When the metal connecting piece and the rotating shaft 1316 are of an integrated structure, a connection relationship between the metal connecting piece and the rotating shaft 1316 cannot be broken. For example, the metal connecting piece and the rotating shaft 1316 may be manufactured in an integrated molding manner, and the metal connecting piece may be a part of the rotating shaft 1316. For another example, the metal connecting piece and the rotating shaft 1316 may be assembled in a connection manner such as welding or riveting.

The handle assembly 132 of the rotary switch 130 includes a rotation handle 1321 and a shaft sleeve 1322. The rotation handle 1321 is located on an outer side of the case 110 of the photovoltaic inverter. A side wall that is of the case 110 and that is close to the rotation handle 1321 is provided with a through hole. The shaft sleeve 1322 extends into the accommodating cavity (specifically the first cavity) enclosed by the case 110 through the through hole, and is rotatably connected to the rotating shaft 1316. That is, the rotation handle 1321 is rotatably connected to the rotating shaft 1316 through the shaft sleeve 1322 extending into the accommodating cavity (specifically the first cavity) enclosed by the case 110. When a user controls the rotation handle 1321 to rotate, the shaft sleeve 1322 may be driven to rotate, to drive the rotating shaft 1316 to rotate, conducting or cutting off a current of the rotary switch 130.

To ensure stability of electrical performance of the photovoltaic inverter, pins of two adjacent poles need to be spaced apart for a distance from each other. For example, the first pin 1311 and the second pin 1312 need to be spaced apart for a distance from each other. However, in a case of a large current or a high voltage, a thickness of the rotary switch may be increased. This is unconducive to development of miniaturization and integration of the rotary switch and the photovoltaic inverter.

In this embodiment of this application, an outer side wall that is of the insulation housing 1315 and that is close to the circuit board 120 is provided with a plurality of grooves. Openings of the plurality of grooves are located on a side that is of the insulation housing 1315 and that is close to the circuit board 120. Each groove is located between the pins of the two adjacent poles. For example, the plurality of grooves include a first groove 13151 and a second groove 13152. The first groove 13151 is located between the first pin 1311 and the second pin 1312, and the second groove 13152 is located between the third pin 1313 and the fourth pin 1314.

It should be noted that, the first pin 1311 and the second pin 1312 are pins of the first pole of the rotary switch 130, and the third pin 1313 and the fourth pin 1314 are pins of the second pole of the rotary switch 130. The first pole and the second pole are two adjacent poles. It may be understood that the first pin 1311 and the second pin 1312 are two pins that are located on a same side and that are of two adjacent poles.

It should be understood that the first pin 1311 and the second pin 1312 are two adjacent pins, and the third pin 1313 and the fourth pin 1314 are two adjacent pins. In other words, the first pin 1311 and the second pin 1312 are located on a same side, and the third pin 1313 and the fourth pin 1314 are located on the other side. Alternatively, the first pin 1311 and the second pin 1312 are electrically connected to the photovoltaic connector 140 through the metal trace on the circuit board 120, and the third pin 1313 and the fourth pin 1314 are electrically connected to the inverter circuit (or the DC/DC circuit) on the circuit board 120 through the metal trace on the circuit board 120.

It should be understood that there may be one or more grooves between pins of two adjacent poles. For example, the insulation housing 1315 may be further provided with more grooves between the first pin 1311 and the second pin 1312, and the insulation housing 1315 may be further provided with more grooves between the third pin 1313 and the fourth pin 1314. A quantity of grooves between two adjacent pins is not limited in embodiments of this application.

It should be understood that a quantity of grooves between the first pin 1311 and the second pin 1312 may be the same as or different from a quantity of grooves between the third pin 1313 and the fourth pin 1314.

Optionally, as shown in FIG. 5, a length of the groove in the X direction is greater than or equal to a width of the pin in the X direction.

In this embodiment of this application, the insulation housing is provided with the groove between the pins of the two adjacent poles, so that a creepage distance between the pins of the two adjacent poles can be increased. This ensures stability and safety of electrical performance of the photovoltaic inverter.

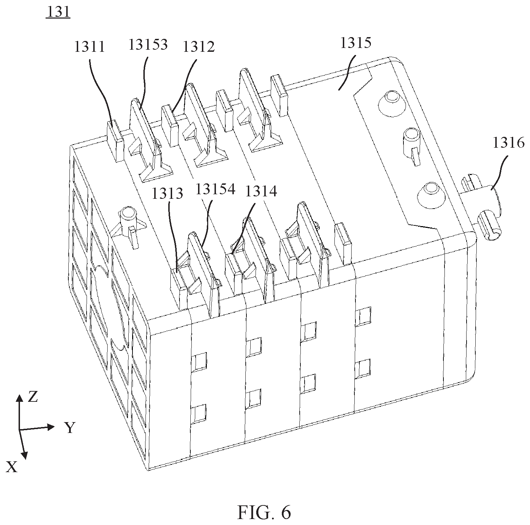

FIG. 6 is a diagram of a structure of another rotary switch according to an embodiment of this application.

As shown in FIG. 6, the outer side wall that is of the insulation housing 1315 and that is close to the circuit board 120 is provided with a plurality of bosses. The plurality of bosses are located between the insulation housing 1315 and the circuit board 120. Each boss is located between the pins of the two adjacent poles.

It should be understood that the boss is a structure of a protrusion on the insulation housing 1315, and portions that are located between the insulation housing 1315 and the circuit board 120 and that are of the pins of the two adjacent poles may be separated by the boss.

For example, as shown in FIG. 6, the plurality of bosses may include a first boss 13153 and a second boss 13154. The first boss 13153 is located between the first pin 1311 and the second pin 1312, and the second boss 13154 is located between the third pin 1313 and the fourth pin 1314.

It should be understood that there may be one or more bosses between the pins of the two adjacent poles. For example, the insulation housing 1315 may be further provided with more bosses between the first pin 1311 and the second pin 1312, and the insulation housing 1315 may be further provided with more bosses between the third pin 1313 and the fourth pin 1314. A quantity of bosses between the two adjacent pins is not limited in embodiments of this application.

It should be understood that a quantity of bosses between the first pin 1311 and the second pin 1312 may be the same as or different from a quantity of bosses between the third pin 1313 and the fourth pin 1314.

It should be understood that the boss is made of an insulation material, for example, plastic. A material of the boss may be the same as or different from a material of the insulation housing 1315.

It should be understood that the boss and the insulation housing 1315 may be of an integrated structure, or may be of a separate structure. This is not limited in embodiments of this application. When the boss and the insulation housing 1315 are of a separate structure, the boss and the insulation housing 1315 are two different components, and the boss and the insulation housing 1315 may be assembled together through clamping, fastening, a screw, a bolt, or the like, and may be separated when the boss and the insulation housing 1315 need to be disassembled. When the boss and the insulation housing 1315 are of an integrated structure, a connection relationship between the boss and the insulation housing 1315 cannot be broken. For example, the boss and the insulation housing 1315 may be manufactured in an integrated molding manner, and the boss may be a part of the insulation housing 1315.

Optionally, as shown in FIG. 6, a height of the boss in the Z direction is greater than or equal to a height of a portion of the pin extending out of the insulation housing 1315 in the Z direction.

Optionally, as shown in FIG. 6, a width of the boss in the X direction is greater than or equal to a width of the pin in the X direction.

In this embodiment of this application, portions that are located between the insulation housing 1315 and the circuit board 120 and that are of the pins of the two adjacent poles may be separated by the boss, so that a creepage distance between the pins of the two adjacent poles can be increased. This ensures stability and safety of electrical performance of the photovoltaic inverter.

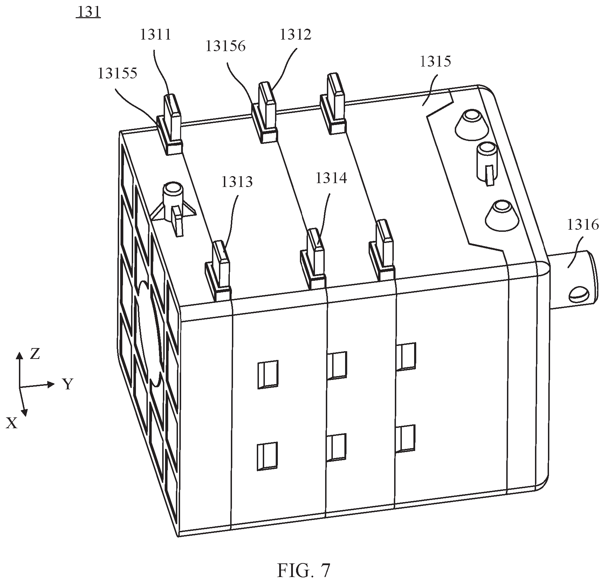

FIG. 7 is a diagram of a structure of another switch body according to an embodiment of this application.

As shown in FIG. 7, the outer side wall that is of the insulation housing 1315 and that is close to the circuit board 120 is provided with a plurality of ribs. The plurality of ribs protrude from a side that is of the insulation housing 1315 and that is close to the circuit board 120. The plurality of ribs are in a one-to-one correspondence with the plurality of pins of the rotary switch 130. For example, a first rib 13155 corresponds to the first pin 1311, and a second rib 13156 corresponds to the second pin 1312.

For example, the second rib 13156 may include a first portion, a second portion, and a third portion. One end of the first portion is connected to the second portion, the other end of the first portion is connected to the third portion, and the second portion and the third portion are disposed opposite to each other. In addition, the first portion is located on a side that is of the second pin 1312 and that is close to the first pin 1311. The first portion, the second portion, and the third portion form the second rib 13156.

It should be understood that a cross section of the pin in embodiments of this application is a rectangle, and the second rib 13156 surrounds three side surfaces of a portion of the second pin 1312 extending out of the insulation housing 1315.

For the first rib 13155, the first rib 13155 may also include a first portion, a second portion, and a third portion. One end of the first portion is connected to the second portion, the other end of the first portion is connected to the third portion, and the second portion and the third portion are disposed opposite to each other. The first portion may be located on a side that is of the first pin 1311 and that is away from the second pin 1312.

In some embodiments, because there is no pin on the side that is of the first pin 1311 and that is away from the second pin 1312, the first portion of the first rib 13155 may also be located on a side that is of the first pin 1311 and that is close to the second pin 1312.

It should be understood that at least portions/a portion of the first rib 13155 and/or the second rib 13156 are/is located between the first pin 1311 and the second pin 1312. The first pin 1311 belongs to the first pole of the rotary switch 130, the second pin 1312 belongs to the second pole of the rotary switch 130, and the first pole and the second pole are two adjacent poles.

It should be understood that the first pin 1311 and the second pin 1312 are two adjacent pins, and the third pin 1313 and the fourth pin 1314 are two adjacent pins. In other words, the first pin 1311 and the second pin 1312 are located on a same side, and the third pin 1313 and the fourth pin 1314 are located on the other side. Alternatively, the first pin 1311 and the second pin 1312 are electrically connected to the photovoltaic connector 140 through the metal trace on the circuit board 120, and the third pin 1313 and the fourth pin 1314 are electrically connected to the inverter circuit (or the DC/DC circuit) on the circuit board 120 through the metal trace on the circuit board 120.

It should be understood that the first rib and the second rib are two adjacent ribs located on a same side, and the first rib and the second rib may be understood as two ribs corresponding to the two pins of the two adjacent poles.

In some embodiments, for the first rib 13155, the first rib 13155 may further include a fourth portion. The fourth portion is disposed opposite to the first portion, and two ends of the fourth portion are respectively connected to the second portion and the third portion. The first portion may be located on the side that is of the first pin 1311 and that is away from the second pin 1312, and the fourth portion may be located on the side that is of the first pin 1311 and that is close to the second pin 1312. Similarly, for the second rib 13156, the second rib 13156 may also include a fourth portion. The fourth portion is located on the side that is of the second pin 1312 and that is away from the first pin 1311. That is, the four portions of each rib are sequentially connected, and each rib surrounds a periphery of the portion of the pin extending out of the insulation housing 1315. For example, the first rib 13155 surrounds a periphery of a portion of the first pin 1311 extending out of the insulation housing 1315, and the second rib 13156 surrounds a periphery of a portion of the second pin 1312 extending out of the insulation housing 1315.

In some embodiments, an inner side surface of the rib and the portion that is of the pin and that is located between the insulation housing 1315 and the circuit board 120 are attached together.

It should be understood that for a structure of another rib, refer to related descriptions of the first rib 13155 and the second rib 13156. Details are not described herein again.

In this embodiment of this application, a periphery of each pin is surrounded by the rib, and at least portions of two adjacent ribs are located between the two pins that are located on a same side and that are of the two adjacent poles, so that a creepage distance and an electrical clearance between the two pins located on the same side are increased. This ensures stability and safety of electrical performance of the photovoltaic inverter.

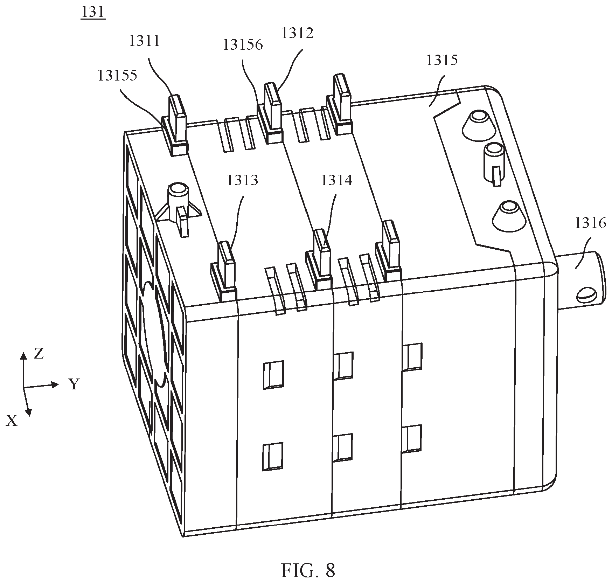

FIG. 8 is a diagram of a structure of a switch body according to an embodiment of this application. As shown in FIG. 8, the insulation housing 1315 may be further provided with a groove between the first rib 13155 and the second rib 13156, to increase a creepage distance between the first pin 1311 and the second pin 1312. For a structure of the groove, refer to related descriptions in the embodiment shown in FIG. 5. Details are not described herein again.

It should be understood that the first rib 13155 is a rib corresponding to the first pin 1311, the second rib is a rib corresponding to the first pin 1311. The first pin 1311 belongs to the first pole of the rotary switch 130, the second pin 1312 belongs to the second pole of the rotary switch 130, and the first pole and the second pole are two adjacent poles. It may be understood that the first pin 1311 and the second pin 1312 are two pins that are located on a same side and that are of two adjacent poles.

It should be understood that there may be one or more grooves between the first rib 13155 and the second rib 13156. This is not limited in embodiments of this application.

In some embodiments, a boss (not shown in the figure) may be further provided between the first rib 13155 and the second rib 13156, to increase a creepage distance and an electrical clearance between the first pin 1311 and the second pin 1312. For a structure of the boss, refer to related descriptions in the embodiment shown in FIG. 6. Details are not described herein again.

There may be one or more grooves between the first rib 13155 and the second rib 13156. This is not limited in embodiments of this application.

It should be understood that there may be one or more bosses between the first rib 13155 and the second rib 13156. This is not limited in embodiments of this application.

## Claims

1. A photovoltaic inverter, comprising:
a rotary switch (130), wherein the rotary switch (130) comprises a switch body (131), the switch body (131) comprises an insulation housing (1315) and a plurality of pins, the switch body (131) comprises a plurality of pins, and the plurality of pins extend out of the insulation housing (1315); and
the rotary switch (130) is a multipole switch, each pole of the rotary switch (130) comprises two pins, the insulation housing (1315) is provided with a groove between two pins that are located on a same side and that are of two adjacent poles, and an opening of the groove is located on a side, on which the plurality of pins are located, of the insulation housing (1315), or a boss is formed on an outer side wall of the insulation housing (1315), and the boss is located between the two pins that are located on the same side and that are of the two adjacent poles.

2. The photovoltaic inverter according to claim 1, wherein the photovoltaic inverter further comprises a circuit board (120), portions of the plurality of pins extending out of the insulation housing (1315) are located between the insulation housing (1315) and the circuit board (120), and ends of the plurality of pins extending out of the insulation housing (1315) are connected to a side that is of the circuit board (120) and that is close to the insulation housing (1315).

3. The photovoltaic inverter according to claim 2, wherein the photovoltaic inverter further comprises a case (110), the circuit board (120) is located in an accommodating cavity enclosed by the case (110), the circuit board (120) divides the accommodating cavity enclosed by the case (110) into a first cavity and a second cavity, the first cavity is accommodation space enclosed by the circuit board (120), a bottom plate of the case (110), and a side plate of the case (110), the second cavity is accommodation space enclosed by the circuit board (120), a top plate of the case (110), and the side plate of the case (110), a distance between the circuit board (120) and the bottom plate is greater than a distance between the circuit board (120) and the top plate, a height of an electrical component connected to a side that is of the circuit board and that is close to the bottom plate is greater than or equal to a first preset value, a height of an electrical component connected to a side that is of the circuit board and that is close to the top plate is less than or equal to a second preset value, the first preset value is greater than the second preset value, and the switch body (131) is located in the first cavity.

4. The photovoltaic inverter according to claim 2 or 3, wherein a side wall that is of the insulation housing (1315) and that is close to the circuit board (120) is provided with a plurality of through holes, the plurality of pins are in a one-to-one correspondence with the plurality of through holes, and the plurality of pins extend out of the insulation housing (1315) through the plurality of through holes.

5. The photovoltaic inverter according to claim 2 or 3, wherein the plurality of pins are connected to the circuit board (120) through welding.

6. The photovoltaic inverter according to claim 2 or 3, wherein there are one or more grooves between the two pins that are located on the same side and that are of the two adjacent poles, or there are one or more bosses between the two pins that are located on the same side and that are of the two adjacent poles.

7. A photovoltaic inverter, comprising:
a rotary switch (130), wherein the rotary switch (130) comprises a switch body (131), the switch body (131) comprises an insulation housing (1315) and a plurality of pins, and the plurality of pins extend out of the insulation housing (1315);
the insulation housing (1315) further comprises a plurality of ribs, the plurality of ribs protrude from an outer side wall of the insulation housing (1315), and the plurality of ribs are in a one-to-one correspondence with the plurality of pins; and
the rotary switch (130) is a multipole switch, each pole of the rotary switch (130) comprises two pins, and at least portions of the plurality of ribs are located between two pins that are located on a same side and that are of two adjacent poles.

8. The photovoltaic inverter according to claim 7, wherein the photovoltaic inverter further comprises a circuit board (120), portions of the plurality of pins extending out of the insulation housing (1315) are located between the insulation housing (1315) and the circuit board (120), and the plurality of pins are connected to a side that is of the circuit board (120) and that is close to the insulation housing (1315).

9. The photovoltaic inverter according to claim 8, wherein each of the plurality of ribs surrounds a periphery of a portion that is of a pin and that is located between the insulation housing (1315) and the circuit board (120).

10. The photovoltaic inverter according to claim 8 or 9, wherein the insulation housing (1315) is provided with a groove between two adjacent ribs, an opening of the groove is located on a side, on which the plurality of pins are located, of the insulation housing (1315), and the two adjacent ribs are two ribs corresponding to the two pins that are located on the same side and that are of the two adjacent poles.

11. The photovoltaic inverter according to claim 8 or 9, wherein the insulation housing (1315) further comprises a boss, the boss is located on a side that is of the insulation housing (1315) and that is close to the circuit board (120), the boss is located between the two adjacent ribs, and the two adjacent ribs are two ribs corresponding to the two pins that are located on the same side and that are of the two adjacent poles.

12. A rotary switch, comprising:
a switch body (131), wherein the switch body (131) comprises an insulation housing (1315) and a plurality of pins, the plurality of pins are located in an accommodating cavity enclosed by the insulation housing (1315), the plurality of pins extend out of the insulation housing (1315), and ends of the plurality of pins extending out of the insulation housing (1315) are configured to connect to a circuit board (120) of a photovoltaic inverter; and
the rotary switch (130) is a multipole switch, each pole of the rotary switch (130) comprises two pins, the insulation housing (1315) is provided with a groove between two pins that are located on a same side and that are of two adjacent poles, and an opening of the groove is located on a side, on which the plurality of pins are located, of the insulation housing (1315), or the insulation housing (1315) comprises a boss, the boss is located on a side that is of the insulation housing (1315) and that is close to the circuit board (120), and the boss is located between the two pins that are located on the same side and that are of the two adjacent poles.

13. The rotary switch according to claim 12, wherein the photovoltaic inverter further comprises a case (110), the circuit board (120) is located in an accommodating cavity enclosed by the case (110), the circuit board (120) divides the accommodating cavity enclosed by the case (110) into a first cavity and a second cavity, the first cavity is accommodation space enclosed by the circuit board (120), a bottom plate of the case (110), and a side plate of the case (110), the second cavity is accommodation space enclosed by the circuit board (120), a top plate of the case (110), and the side plate of the case (110), a distance between the circuit board (120) and the bottom plate is greater than a distance between the circuit board (120) and the top plate, a height of an electrical component connected to a side that is of the circuit board and that is close to the bottom plate is greater than or equal to a first preset value, a height of an electrical component connected to a side that is of the circuit board and that is close to the top plate is less than or equal to a second preset value, the first preset value is greater than the second preset value, and the switch body (131) is located in the first cavity.

14. A rotary switch, comprising:
a switch body (131), wherein the switch body (131) comprises an insulation housing (1315) and a plurality of pins, the plurality of pins are located in an accommodating cavity enclosed by the insulation housing (1315), the plurality of pins extend out of the insulation housing (1315), and ends of the plurality of pins extending out of the insulation housing (1315) are configured to connect to a circuit board (120) of a photovoltaic inverter;
the insulation housing (1315) further comprises a plurality of ribs, the plurality of ribs protrude from a side wall that is of the insulation housing (1315) and that is close to the circuit board (120), and the plurality of ribs are in a one-to-one correspondence with the plurality of pins; and
the rotary switch (130) is a multipole switch, each pole of the rotary switch (130) comprises two pins, and at least portions of the plurality of ribs are located between two pins that are located on a same side and that are of two adjacent poles.

15. The rotary switch according to claim 14, wherein the insulation housing (1315) is provided with a groove between two adjacent ribs, an opening of the groove is located on a side, on which the plurality of pins are located, of the insulation housing (1315), and the two adjacent ribs are two ribs corresponding to the two pins that are located on the same side and that are of the two adjacent poles.

16. The rotary switch according to claim 14, wherein the insulation housing (1315) further comprises a boss, the boss is located on a side that is of the insulation housing (1315) and that is close to the circuit board (120), the boss is located between the two adjacent ribs, and the two adjacent ribs are two ribs corresponding to the two pins that are located on the same side and that are of the two adjacent poles.

17. The rotary switch according to claim 15, wherein the insulation housing (1315) further comprises a boss, the boss is located on a side that is of the insulation housing (1315) and that is close to the circuit board (120), and the boss is located between the two adjacent ribs.
